Europäisches Patentamt

European Patent Office

Office européen des brevets

(11) Publication number: 0 510 618 A1

# EUROPEAN PATENT APPLICATION

(21) Application number: 92106891.2

(22) Date of filing: 22.04.92

(51) Int. Cl.5: H01J 37/20

(30) Priority: 26.04.91 JP 122931/91

(43) Date of publication of application:
28.10.92 Bulletin 92/44

(84) Designated Contracting States:
DE NL

(71) Applicant: HITACHI, LTD.
6, Kanda Surugadai 4-chome
Chiyoda-ku, Tokyo 100(JP)
Applicant: Hitachi Instrument Engineering
Co., Ltd.
832-2, Nagakubo, Horiguchi
Katsuta-shi Ibaraki-ken(JP)

(72) Inventor: Ukiana, Motohide
1452-2, Tabiko
Katsuta-shi(JP)
Inventor: Kobayashi, Hiroyuki
2-35, Kamimito-1-chome
Mito-shi(JP)
Inventor: Yotsuji, Takafumi
Nakaryo 101, 906,2
Ichige, Katsusta-shi(JP)

(74) Representative: Strehl, Schübel-Hopf,
Groening
Maximilianstrasse 54 Postfach 22 14 55
W-8000 München 22(DE)

(54) Electron microscope.

(57) A transmission type electron microscope in accordance with an embodiment of the present invention comprises a main body. The main body includes a sample carrying means (10) for carrying a plurality of samples (4) to allow sequential observation of the samples. Although a carrier means in the prior art is of a manual type, the carrier means in the present invention can be operated from a distance place on a remote control basis, thus securing a safety in its sample observation works. Further, since an acceleration voltage and other measuring conditions as well as a means for finely moving a sample in the main body can be controlled from a location away from the main body, a plurality of users can commonly use the main body.

FIG. I

## BACKGROUND OF THE INVENTION

The present invention generally relates to electron microscope and, more particularly, to an electron microscope in which changing over between a plurality of samples as well as fine moving operation of a sample are carried out by means of a motor to allow a multiplicity of samples to be observed on a remote control basis.

There are two ways of observing an image in an electron microscope, viz., one method of projecting an electron beam transmitted through a sample onto an observing fluorescent screen for its observation and the other method of converting the electron beam into an electric signal to display it on a CRT for its indirect observation.

In the former observation method using the observation fluorescent screen, the microscope must be placed in a dark space and the number of observers is also limited. For this reason, in these years, the latter observation method using the CRT has been increasingly employed.

Upon observation, irradiation of an electron beam onto a sample at a high acceleration voltage may cause unfavorable development of much X rays. To avoid this, it is required to apply some measure of preventing the X-ray leakage to the main body of the electron microscope. For example, it is considered to adjust the material and/or thickness of a column wall in the microscope. Even when a sample to be observed is made of radioactive material, the same consideration must be paid. The application of such X-ray leakage prevention measure results in some restriction to the performance of the electronic microscope, e.g. the main body of the microscope is made large in size.

In order to avoid this, the input part of the microscope for setting and modifying such observation conditions as an acceleration voltage and a magnification has been recently provided separately from the main body of the microscope to allow its remote setting and modification. With the separate provision between the main body and input part, even when X rays are generated in the main body, an operator in front of the input part can avoid the X ray influence.

Further, the main body of the electron microscope is usually provided with a finely moving mechanism for finely changing the observation field of a sample. There has been conventionally known an electron microscope which an input part for entering commands or data necessary for actuating the fine moving mechanism is provided as separated from a main body as mentioned above. The input part is controlled usually by a computer.

Meanwhile, sample exchange involves operator's troublesome labor in the observation of an image of the electron microscope. For the purpose of saving or reducing such troublesome labor, there have been suggested sample transport devices which can carry a multiplicity of samples, as disclosed, for example, in JP-Y2-51-26611, JP-A-52-119948 and JP-A-61-200657.

In JP-Y2-51-26611 and JP-A-61-200657, a plurality of sample holders are linearly moved. A mechanism for transport is mounted integrally to a column in the main body of an electron microscope so that an operator turns its knob to move predetermined one of the sample holders up to an observation field, i.e., such a field at which an electron beam is irradiated.

In JP-A-52-119948, a plurality of sample holders are moved along a circular shift path. A mechanism for transport is mounted integrally to a column in the main body of an electron microscope so that an operator directly handles it.

With such transport devices as mentioned above, since the operator must make access to the main body, some measure for reliably preventing the leakage of X rays or other radiations must be provided to the main body.

## SUMMARY OF THE INVENTION

It is an object of the present invention to provide an electronic microscope which can eliminate the need for provision of a special means for preventing leakage of X rays and other radiations.

Another object of the present invention is to provide an electronic microscope which is high in safety.

A further object of the present invention is to provide an electronic microscope which allows an operator to set and/or modify the operating conditions of a main body of the microscope and also to select and finely move observation samples at a distance location.

Yet a further object of the present invention is to provide an electronic microscope which has a high resolution power.

In order to attain at least one of the above objects, in accordance with the present invention, a transport means for sample holders is arranged to be operated at a location away from the main body of the microscope, for example, by an input controller located in an experimental room different from a room in which the main body is located.

The transport means and finely moving means are mounted as projected from a column in a main body of the electronic microscope. In order to operate these transport means and finely moving means, these means must be connected to the input controller through cords. Since the transport and finely moving means themselves can move, the interconnection between these means and the input controller becomes difficult. When a sag is given to the cords to accommodate such motions in these means, the cord will sag from these means. The sagged cord may swing with the operation of these means. The swinging of the cord adversely affects an image when observation is conducted with a high magnification as high as nano-order.

For the purpose of avoiding such a problem, in the present invention, the need for connecting the transport and finely moving means to the input controller by means of the cords are eliminated and instead the transport and finely moving means are operated on a remote control basis.

In the present invention, further, the main body and the sample holder transport means and finely moving means associated therewith are completely separated and isolated from the input controller for controlling these means. As a result, when suitable interfaces are provided to the former and a plurality of such input controllers are provided, a plurality of users can commonly use the main body.

BRIEF DESCRIPTION OF THE DRAWINGS

These and other objects and technical advantages of the present invention will be readily apparent from the following description of the preferred exemplary embodiments of the invention in conjunction with the accompanying drawings, in which:

Fig. 1 is a block diagram of a transmission type electronic microscope in accordance with an embodiment of the present invention;
Fig. 2 is a horizontal cross-sectional view taken along a sample fine moving/transport part 10;
Fig. 3 is a plan view of a sample change-over mechanism;
Fig. 4 is an exploded perspective view of the sample change-over mechanism; and
Figs. 5 and 6 are block diagrams of transmission type electronic microscopes in accordance with other embodiments of the present invention respectively.

DESCRIPTION OF THE PREFERRED EMBODIMENTS

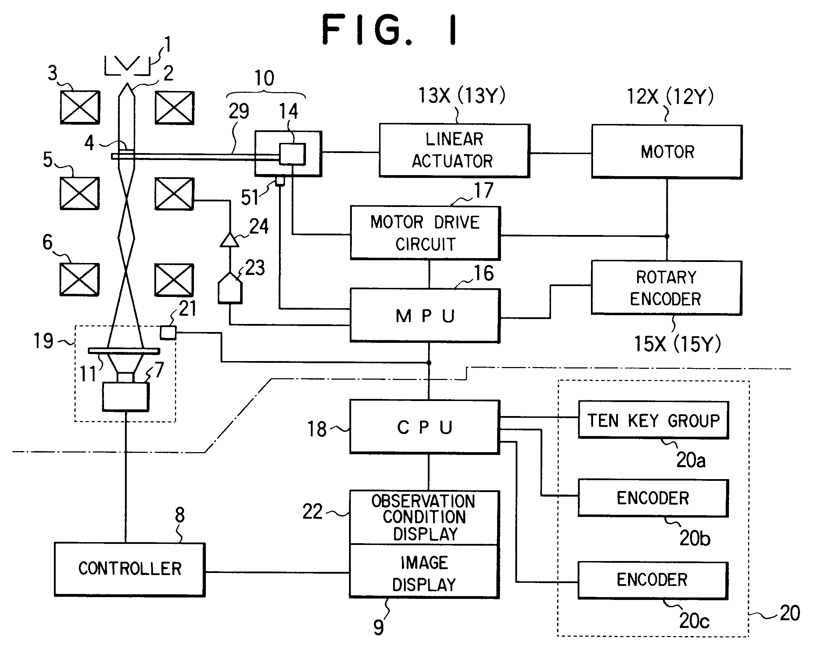

Referring first to Fig. 1, there is shown a block diagram of a transmission type electronic microscope in accordance with an embodiment of the present invention.

In the drawing, an electron beam 2 irradiated from an electron gun 1 is condensed by an irradiation lens system 3 and then irradiated onto a sample 4 located at its observation position. The electron beam 2 transmitted through the sample 4 is magnified and focused by an objective lens 5, magnified by an imaging lens system 6 and then projected onto a television fluorescent plate 11 in an electron beam detector 19.

A microscopic image formed on the television fluorescent screen 11 is taken into a TV camera 7. The TV camera 7 comprises a charge coupled device (CCD) which detects a visible ray. A video signal issued from the TV camera 7 is displayed as a microscopic image on an image display 9 installed at a place away from the electron microscope under control of a controller 8.

When it is desired to record the microscopic image, a film (not shown) is carried on the television fluorescent screen 11 to expose the film to the electron beam 2. Mounted to a side wall of the electron beam detector 19 is a vacuum fluorescent tube 21 to indicate an identified data on the sample under measurement, which identified data indicated on the tube 21 is projected on the film through a lens system (not shown). As a result, the microscopic image and its identified data are both recorded on the film.

A sample fine moving/transport part 10 mainly includes a sample carrier 29 and a motor 14. The sample carrier 29 is formed in its tip end with an elliptical sample transport path of a doughnut shape to be explained later. A plurality of samples 4 are loaded along the sample transport path. The motor 14 is a drive source which moves the plurality of samples 4 circulatingly along the sample transport path to sequentially locate the samples switchingly on the optical axis of the electron beam.

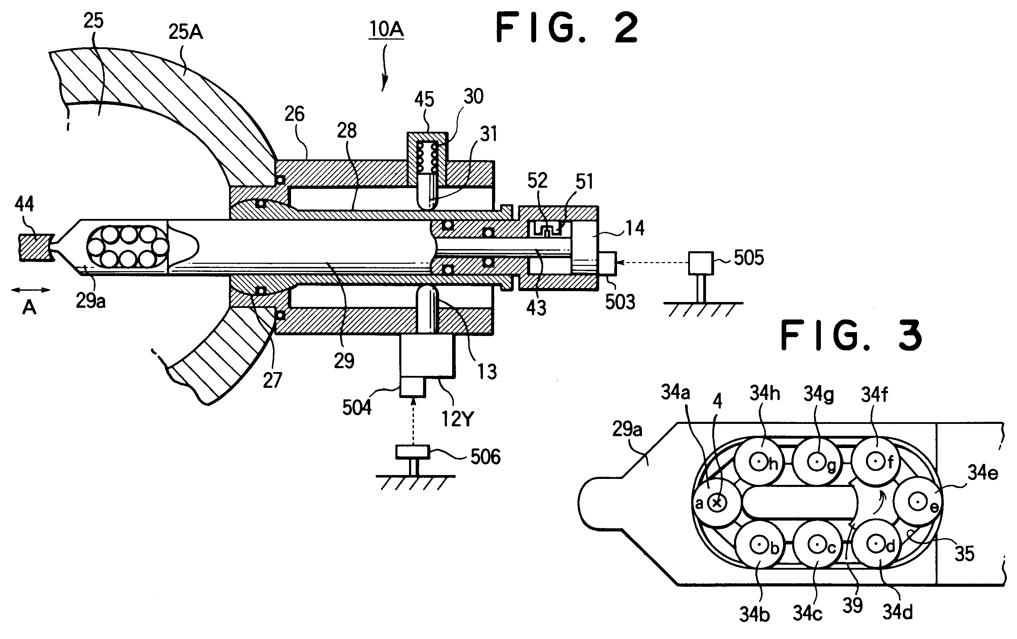

The tip end of the sample carrier 29 is reciprocatingly moved by actuators 13X (13Y) driven by the motors 12X (12Y) in X and Y axis directions (perpendicular to the electron beam). The structure of the sample fine moving/transport part 10 will be later detailed by referring to Fig. 2.

The motors 12X (12Y) are connected with rotary encoders 15X (15Y) respectively which have a common rotary shaft. Pulse signals issued from the rotary encoders 15X (15Y) are applied to a microprocessor (which will be referred to merely as the MPU, hereinafter) 16. The MPU 16 functions to control various parts in the electron microscope, that is, to control a motor drive circuit 17 for control of the motors 12X (12Y) and 14 and also to control the objective lens 5 for focusing at the time of observation.

The MPU is connected to an external CPU 18 for remote control installed at a place away from the electron microscope, to which external CPU 18 a remote controller 20 is connected. The remote controller 20 includes mainly a ten key group 20a and encoders 20b and 20c. The CPU 18 and the remote controller 20 make up an input control means.

An operator enters a number for specifying a desired sample (sample holder) through the ten key group 20a, whereby a key signal corresponding to the entered number is sent from the ten key group 20a to the MPU 16. A pulse signal for finely moving the observation position is output from the encoder 20b in response to operator's operation. A pulse signal for focusing at the time of observation is output from the encoder 20c in response to operator's operation.

An observation condition display 22 is used to display thereon various observation conditions such as a magnification and an acceleration voltage. An exciting current data issued from the MPU 16 is converted at a D/A converter 23 into an exciting current, amplified at an amplifier 24 and then sent to the objective lens 5.

The aforementioned arrangement is substantially the same as that of transmission type electron microscopes being marketed in U.S.A under the trade name of H-7100 which assignee, Hitachi, Ltd., is the same as the present application, except for the sample transport means, e.g., the motor 14.

Shown in Fig. 2 is a horizontal cross-sectional view of the electronic microscope taken along the sample fine moving/transport part 10.

In the drawing, a sample chamber 25 surrounded by a side wall 25A of the electron microscope is kept in a vacuum state. Sealingly attached to the side wall 25A is a receiving metallic fitting 26 in which an oscillating motion shaft 28 is inserted for oscillating movement on a spherical part 27. The hollow sample carrier 29, which is axially extended, is sealingly passed from the outside of the sample chamber 25 through the oscillating motion shaft 28 into the inside of the chamber 25. Inserted into the sample carrier 29 is a rotary shaft 43 which is extended up to the interior of the sample chamber 25 and which is also coupled at the other end with the motor 14.

The sample carrier 29 is held as grasped by the linear actuator 13 which changes the rotational movement of the motor 12Y into a translational or linear movement and by a pressing pin 31 resiliently supported by a return spring 30, so that the operation of the linear actuator 13 causes a tip end 29a of the sample carrier 29 to oscillatingly move with the spherical part 27 at its oscillating pivot or node. A carrier receiver 44 is reciprocatingly moved by means of the motor 12X (already explained in Fig. 1) in such directions as shown by an arrow A in the drawing.

Provided in the tip end 29a of the sample carrier 29 is a sample transport mechanism in which 8 sample holders 34a to 34h in a sample transport path is moved along the transport path by means of a feeding wheel 39 as shown in Fig. 3. The sample transport path 35 comprises an elliptical groove formed in the tip end 29a.

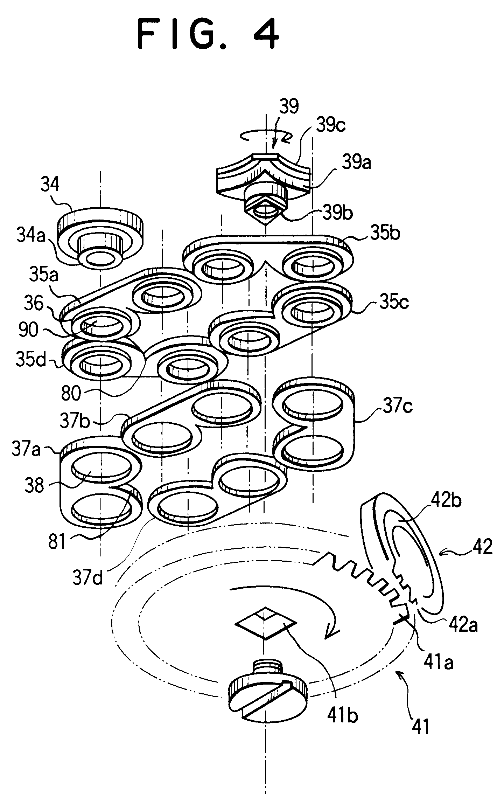

Fig. 4 is an exploded perspective view of a structure of the sample transport mechanism, in which parts having the same or equivalent functions as those in Fig. 3 are denoted by the same reference numerals or symbols. In the drawing, the sample transport mechanism includes 4 upper-side linkage members each having two openings 90 and made in the form of a pair of glasses or spectacles, lower-side linkage members each having two openings 38, the aforementioned feeding wheel 39, a wheel 41 having a square hole therein, and a transmission wheel 42. Each of the upper-side linkage members is formed with projections 36 which surround the associated openings 90.

The four upper-side linkage members 35a to 35d are arranged in the form of a ring and adjacent two of the upper-side linkage members are fitted at their projections 36 around the openings 90 into the openings 38 of associated one of the lower-side linkage members 37a to 37d, so that the upper- and lower-side linkage members 35a to 35d and 37a to 37d are linked together to form a linked chain. The upper- and lower-side linkage members 35a to 35d and 37a to 37d mutually linked are coated with such lubricating agent as molybdenum disulfide on their sliding surfaces.

Meanwhile, each sample holder 34 having a projection 34a is fitted into one of the openings 90 of the upper-side linkage members to be removably supported. At this time, the sample holder 34 is supported in the upper-side linkage members with a predetermined orientation thereto.

The feeding wheel 39 has a meshing portion 39a provided at its four corners with 1/4-circumferential nails which engage with a notch 81 of each of the lower-side linkage members 37a to 37d, a square portion 39b engaged in the square-hole wheel 41 to be explained later, and a depressing portion 39c for depressing the linkage members against their upward shift.

The square-hole wheel 41 has a gear portion 41a and a square hole 41b fittingly receiving the square portion 39b of the feeding wheel 39. The transmission wheel 42 has a gear portion 42a and an engagement portion 42b for engagement with the rotary shaft 43. The gear portion 41a of the square-hole wheel 41 is meshed with the gear portion 42a of the transmission wheel 42.

Now, when the transmission wheel 42 is rotated to rotate the feeding wheel 39 through the square-hole wheel 41 under control of the motor 14, the nails of the feeding wheel 39 engage in the notches 80 and 81 of the upper-side and lower-side linkage members, whereby the linked chain is driven along the transport path.

For example, when the sample holder 34a is moved in a direction shown by an arrow from its observation position as shown in Fig. 3, the linkage members carrying the sample holders 34d, 34e and 34f receive a feeding force through the direct operation of the nails of the feeding wheel 39 and also the linkage members carrying the sample holders 34g and 34h downstream the sample holder 34f are subjected to a pushing force. Similarly, the linkage members carrying the sample holders 34b and 34c upstream the sample holder 34d are subjected to a pulling force.

As a result, the respective sample holders 34a to 34h can be smoothly moved along the sample transport path 35.

Turning back to Fig. 2, the rotary shaft 43 of the motor 14 is provided with an initial position detection plate 52 so that a sensor 51 can detect the presence or absence of the initial position detection plate 52. The initial position detection plate 52 is mounted on the shaft 43 at such a position that the sensor 51 can detect the presence of the specific sample holder (e.g., sample holder 34a) as a reference when located at the observation position.

When the operator instructs the initializing operation, the motor 14 rotates until the sensor 51 detects the presence of the initial position detection plate 52. When the sensor 51 detects the initial position detection plate 52, a pulse counter PC for counting a pulse signal to be supplied to the motor 14 is reset.

The positions of the respective sample holders 34a to 34h in the transport path 35 are managed by the pulse counter PC. For example, the electronic microscope is previously set so that the sample holder 34h reaches the observation position when the count value of the pulse counter PC is 100, the sample holder 34b reaches the observation position when the count value is 700, and so on.

With such an arrangement, after samples are placed on the respective sample holders 34a to 34h and the sample carrier 29 having such samples are inserted into the interior of the sample chamber 25, the sample chamber is vacuumized and also initializing operation is executed.

At this time, the sample holder 34a is moved to the observation position so that the operator can observe the sample placed on the sample holder 34a.

When it is desired to change the sample holder 34a located at the observation position to the sample holder 34g, the operator operates the ten key group 20a (refer to Fig. 1) to enter a command corresponding to the sample holder 34g. This causes the motor drive circuit 17 to output a pulse signal to the motor 14 until the count value of the pulse counter PC becomes 200. As a result, the desired sample is directly selected.

A more complete description of the arrangement and operation of the structure of Fig. 4 can be found in a Japanese Patent Application No. Hei 3-6209 filed January 23, 1991, which is incorporated for reference.

In the illustrated embodiment, it was assumed that the sample carrier has a width of 8mm, a center-to-center distance between the openings 38 or 90 of the upper- or lower-side linkage members 35a to 35d or 37a to 37d is 3mm, each opening 38 has a diameter of 1.5mm, and each linkage member has a thickness of 0.2 to 0.3mm.

Embodiment 2:

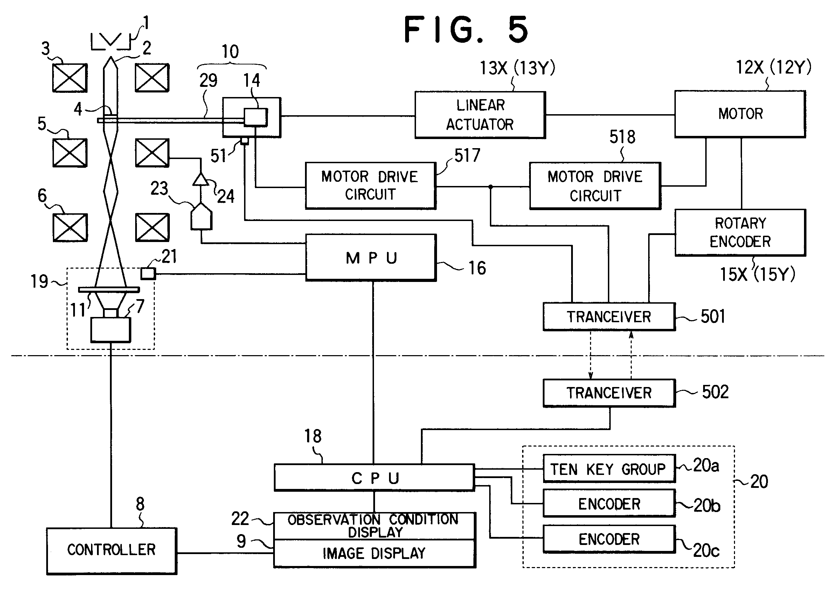

Fig. 5 shows an electron microscope in accordance with another embodiment of the present invention. In the drawing, elements performing substantially the same operation as those in Fig. 1 are denoted by the same reference numerals and symbols and explanation thereof is omitted.

In the present embodiment, transceivers 501 and 502 are provided between the input control side (i.e., the CPU 18 and the remote controller 20) and the main body side (i.e., motor drive circuits 517 and 518, rotary encoders 15X and 15Y, and a sensor 51). In the illustrated embodiment, the transceivers utilize infrared ray. Thus, the main body side can be remote controlled.

For example, this can be realized by mounting infrared ray receivers 503 and 504 respectively to the motors 12Y and 14 of the main body side and by infrared ray transmitters 505 and 506 in the remote control side as opposed to the associated receivers as shown in Fig. 2. If necessary, infrared ray may be replaced by sound wave or electromagnetic wave. The main body side is provided with a power source (not shown), e.g. a battery.

Embodiment 3:

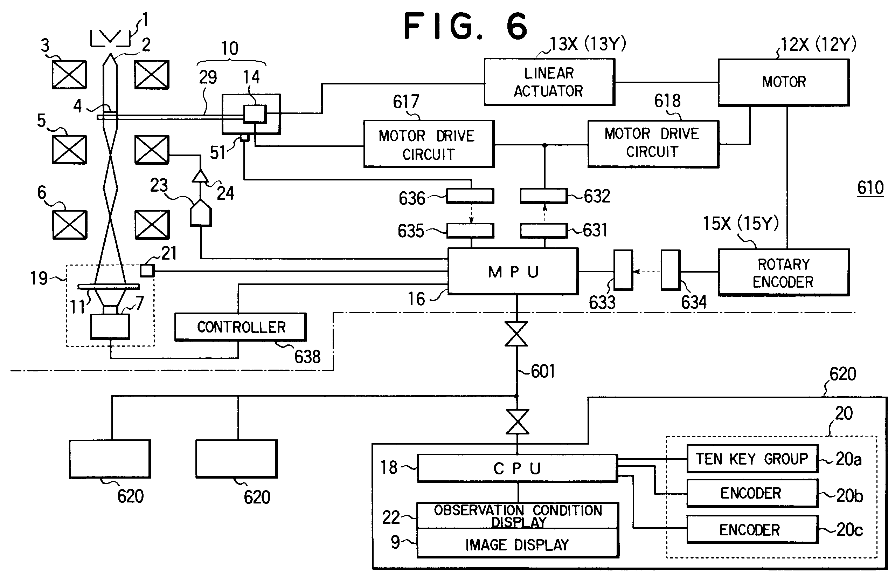

Fig. 6 shows an electron microscope in a further embodiment of the present invention. In the drawing, elements performing substantially the same operation as those in Fig. 1 are denoted by the same reference numerals and symbols and explanation thereof is omitted.

In the present embodiment, a main body section 620 and an input control section 620 are interconnected by means of a telephone line 601. Thus, when a plurality of such input control sections 620 are prepared, a plurality of users can commonly use the single main body section 210 on a time sharing basis.

In the embodiment, more specifically, a transmitter 631 and a receiver 632 are provided between the MPU 16 and motor drive circuits 617 and 618, a receiver 633 and a transmitter 634 are provided between the MPU 16 and the rotary encoders 15X and 15Y, and further a receiver 635 and a transmitter 636 are provided between the MPU 16 and the sensor 51. An output of a controller 638 is once input to the MPU 16 and thereafter transmitted to the image display 9.

A Japanese Paten Application No. Hei 3-122931 filed April 26, 1991 is hereby incorporated herein for reference.

The present invention has been described in detail, it should be understood that various changes, substitutions and alternations can be made hereto without departing from the spirit and scope of the present invention as defined by the appended claims.

**Claims**

1. An electron microscope comprising:

   a column (25A) kept in a vacuum state therein;

   sample carrying means (29) provided therein with a sample transport path (35) for moving a plurality of sample holders (34a-34h) within said column (25A);

   transport means (14,39,41-43) for moving said sample holders (34a-34h) along said sample transport path (35); and

   first input control means (18,20a) provided away from said column (25A) and through which an operator enters a command necessary for control of driving operation of said transport means (14,39,41-43).

2. An electron microscope as set forth in claim 1, wherein said transport means includes a chain made up of mutually linked first and second linkage members (35a-35d,37a-37d) to be moved along said sample transport path (35) and also includes a rotator (39) engaged with said chain to move said chain, said linkage members (35a-35d,37a-37d) carrying said sample holders (34a-34h).

3. An electron microscope as set forth in claim 2, wherein said sample holders (34a-34h) are removably supported to said linkage members (35a-35d,37a-37d).

4. An electron microscope as set forth in claim 1, further comprising means (10,12X,12Y,13,29,44) for finely moving a sample observation field and second input control means (18,20b) through which an operator enters a command necessary for controlling driving operation of said finely moving means (10,12X,12Y,13,29,44), and wherein said second input control means (18,20b) is located away from said column (25A) and in the vicinity of said first input control means (18,20a).

5. An electron microscope as set forth in claim 1, further comprising an identification signal output means (51) for outputting an identification signal for identification of one of said sample holders (34a-34h) located at an observation position, imaging means (7-9) for forming an image of a sample (4) to be observed on the basis of an electron beam affected by said sample (4), and means (22) for displaying on said imaging means (7-9) a data for assignment of said one of the sample holders located at said observation position on the basis of said identification signal, and wherein said imaging means (7-9) is located away from said column (25A) and in the vicinity of said first input control means (18,20a), similarly to said first input control means (18,20a).

6. An electron microscope as set forth in claim 5, further comprising photographing means for exposing a film (11) to the electron beam affected by said sample (4) to photograph the sample (4) and means (21) for exposing said film to the data displayed on said imaging means.

7. An electron microscope as set forth in claim 1, further comprising means (51) for outputting a first position signal when one of said sample holders (34a-34h) as a reference is located at the observation position and means (10,16-18) for moving said chain on the basis of said first position signal to place said reference one of the sample holders (34a-34h) at the observation position.

8. An electronic microscope as set forth in claim 1, further comprising means for outputting a first position signal when one of said sample holders (34a-34h) as a reference is located at the observation position, sample-holder designating means (18,20a) for designating desired one of said sample holders (34a-34h), means (16) for outputting a second position signal indicative of said reference one of the sample holders (34a-34h) when the designated one of the sample holders (34a-34h) is located at the observation position, and means (10,16-18) for moving said chain until said first position signal coincides with said second position signal.

9. An electron microscope as set forth in claim 2, wherein said transport means further includes a motor (14) and a rotary shaft (43) for coupling said motor (14) to said rotator (39), said chain is moved in synchronism with said rotary shaft (43), said rotary shaft (43) is provided with a mark (52) corresponding to reference one of said sample holders (34a-34h), and said electron microscope further comprising means (10,16-18,51) for locating said reference one of the sample holders (34a-34h) when detecting said mark.

10. An electron microscope as set forth in claim 1, wherein said sample carrying means (29) has a portion projected externally from said column (25A), part (14,43) of said transport means is provided to said projection portion, and said first input control means (18,20a) remote-controls said transport means without cord therebetween.

11. An electron microscope as set forth in claim 10, further comprising means (12Y,13,31) for finely moving said projection portion and second input control means through which an operator enters a command necessary for controlling driving operation of said finely moving means (12Y,13,31), and wherein said sample is finely moved when said projection portion is finely moved and said second input control means remote-controls said finely moving means.

12. An electron microscope as set forth in claim 1, wherein said transport means (14,39,41-43) and said first input means (18,20) are interconnected through a telephone line (601) or other communication line.

13. An electron microscope comprising:
    a main body including electron beam emitting means (1), electro-optical system (3,5,6) and a vacuum column (25A);
    first input control means (18,20c) through which an operator enters a command necessary for operation of said main body, said input control means (18,20c) being located away from the main body at such a position as to make negligible effects of X rays and other radiations generated in the main body;
    sample carrying means (29) provided with a sample transport path (35) for moving a plurality of sample holders (34a-34h) within said column (25A);
    transport means (14,39,41-43) for moving said sample holders (34a-34h) along said sample transport path (35); and
    second input control means (18,20a) through which an operator enters a command necessary for control of driving operation of said transport means, said second input control means being located away from said main body similarly to said first input control means.

14. An electron microscope comprising:
    a main body including electron beam emitting means (1), electro-optical system (3,5,6) and a vacuum column (25A);
    first input control means (18,20c) through which an operator enters a command necessary for operation of said main body;
    sample carrying means (29) provided with a sample transport path (35) for moving a plurality of sample holders (34a-34h) within said column (25A);
    transport means (14,39,41-43) for moving said sample holders (34a-34h) along said sample transport path (35);
    second input control means (18,20a) through which an operator enters a command necessary for control of driving operation of said transport means;
    means (10,12X,12Y,13,29,44) for finely moving a sample observation field; and
    third input control means (18,20b) through which an operator enters a command necessary for control of driving operation of said finely moving means (10,12X,12Y,13,29,44),
    wherein said first-to-third input control means are interconnected by means of a telephone line or other communication line.

15. An electron microscope system comprising:
    a main body including electron beam emitting means (1), electro-optical system (3,5,6) and a vacuum column (25A);
    sample carrying means (29) provided with a sample transport path (35) for moving a plurality of sample holders (34a-34h) within said column (25A);
    transport means (14,39,41-43) for moving said sample holders (34a-34h) along said sample transport path (35);
    means for finely moving a sample observation field; and
    a plurality of terminal controllers (620) including first input control means (18,20c) through which an operator enters a command (10,12X,12Y,13,29,44) necessary for operation of said main body, second input control means (18,20a) through which an operator enters a command necessary for control of driving operation of said transport means, and third input control means (18,20b) through which an operator enters a command necessary for control of driving operation of said finely moving means,
    wherein said main body, transport means (14,39,41-43) and finely moving means (10,12X,12Y,13, 29,44) are connected to said terminal controllers (620) through a telephone line or other communication line (601).

# FIG. 1

EP 0 510 618 A1

# FIG. 2

10A

# FIG. 3

EP 0 510 618 A1

# FIG. 4

# FIG. 5

EP 0 510 618 A1

# FIG. 6

EP 0 510 618 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | FR-A-2 046 832 (ASSOCIATED LECTRICAL INDUSTRIES LIMITED) | 1,13 | H01J37/20 |
| A | * page 1, line 19 - page 2, line 15 * <br> * page 7, line 27 - page 8, line 26 * <br> * page 11, line 36 - page 13, line 26 * <br> * page 21, line 24 - page 23, line 12 * <br> * figures 3,4,13,13A,22 * <br> --- | 4,7-11 | |
| D,Y | PATENT ABSTRACTS OF JAPAN <br> vol. 11, no. 33 (E-476)30 January  1987 <br> & JP-A-61 200 657 ( HITACHI LTD. ) 5 September 1986 <br> * abstract * <br> --- | 1,13 | |
| A | DE-A-2 851 640 (HITACHI LTD.) <br> * claims; figures * <br> --- | 5,6 | |
| A | EP-A-0 138 250 (NORTH AMERICAN PHILIPS CORPORATION) <br><br> ----- | | |
| | | | **TECHNICAL FIELDS SEARCHED (Int. Cl.5)** <br><br> H01J |

The present search report has been drawn up for all claims

| Place of search | Date of completion of the search | Examiner |
|---|---|---|
| THE HAGUE | 20 JULY 1992 | SCHAUB G.G. |